# EUROPEAN PATENT APPLICATION

(11) **EP 4 489 304 A2**
(43) Date of publication of application: **08.01.2025**
(21) Application number: 24186421.4
(22) Date of filing: 04.07.2024
(51) Int. Cl.: H03K 17/689, H03K 17/605

(54) **HIGH-VOLTAGE GATE DRIVER INTEGRATED CIRCUIT USING GALVANIC ISOLATOR**

(30) Priority: 05.07.2023 KR 20230087259
(71) Applicant: Wellang Co., Ltd., Seongnam-si, Gyeonggi-do 13486 (KR)
(72) Inventor: HWANG, Jong Tae, 06292 SEOUL (KR)
(74) Representative: Cristinelli, Luca

(57) **Abstract**

A device may include a first region on a substrate including a first integrated circuit (IC1), a second region on the substrate including a second integrated circuit (IC2), and a third region (R1, R2, R3) between the first region and the second region on the substrate. At least one of the first region and the second region may include at least one pattern that provides for signal transmission between the first integrated circuit and the second integrated circuit across a galvanic isolation barrier in the third region.

## Description

### CROSS-REFERENCE TO RELATED APPLICATION

This application is based on and claims priority under 35 U.S.C. §119 to Korean Patent Application No. 10-2023-0087259, filed on July 05, 2023, in the Korean Intellectual Property Office, the disclosure of which is incorporated by reference herein in its entirety.

### BACKGROUND

### 1. Field

One or more embodiments relate to
a high-voltage gate driving IC based on junction isolation, and more specifically, to a high-voltage gate driving IC using a galvanic junction as a level shifter.

### 2. Description of the Related Art

A high-voltage gate driving circuit may be used to drive a switching device that operates at a high voltage with a low driving voltage. The high-voltage gate driving circuit may generally use a level shifter using a high-voltage metal-oxide-semiconductor field-effect transistor (MOSFET) element to convert a low-voltage signal into a high-voltage signal. When only the rising/falling edge information of the input signal is transmitted using a level shifter and a driving signal is reproduced at a high voltage level using a latch circuit from the information to reduce power consumption, the information in the latch may be damaged by noise, and, as a result, a serious malfunction may occur.

The latch circuit may be eliminated by applying a method of driving a galvanic isolator by using a modulator and receiving a signal via a demodulator, and thus, a gate driving circuit that satisfies high reliability may be implemented. However, a gate driving circuit based on a galvanic isolator may not be easy to implement on a single wafer because a modulator circuit and demodulator circuit must be electrically isolated to satisfy insulation.

### SUMMARY

One or more embodiments may implement a modulator of low-voltage side and a demodulator of a high-voltage side in a single wafer by using a semiconductor package, use a galvanic isolator to transmit signals between the modulator and the demodulator, and provide a high-voltage driving integrated circuit having high reliability and a semiconductor package including the integrated circuit.

Additional aspects will be set forth in part in the description which follows and, in part, will be apparent from the description, or may be learned by practice of the presented embodiments of the disclosure.

According to one or more embodiments, a device includes a first region including a first integrated circuit on a substrate, a second region including a second integrated circuit on the substrate, and a third region between the first region and the second region on the substrate, wherein at least one of the first region and the second region includes at least one pattern that provides galvanic isolation between the first integrated circuit and the second integrated circuit on the substrate.

According to an embodiment, the at least one pattern may include a first pattern and a second pattern respectively corresponding to a first electrode of a first capacitor and a first electrode of a second capacitor in a first conductive layer, and a third pattern and a fourth pattern respectively corresponding to a second electrode of the first capacitor and a second electrode of the second capacitor in a second conductive layer.

According to an embodiment the at least one pattern may further include a fifth pattern and a sixth pattern respectively corresponding to a first electrode of a third capacitor and a first electrode of a fourth capacitor in the first conductive layer, and a seventh pattern and an eighth pattern respectively corresponding to a second electrode of the third capacitor and a second electrode of the fourth capacitor in the second conductive layer, wherein the first to fourth patterns may be included in the first region and the fifth to eighth patterns may be included in the second region, wherein the first pattern and the fifth pattern may be electrically connected to each other through a pattern crossing the third region and the second pattern and the sixth pattern may be electrically connected to each other through a pattern crossing the third region.

According to an embodiment, the device may further include a first inductor and a second inductor connected in series between the first electrode of the first capacitor and the first electrode of the second capacitor, wherein a node to which the first inductor and the second inductor may be connected is biased with a first voltage.

According to an embodiment, the device may further include a third inductor inductively coupled to the first inductor and a fourth inductor inductively coupled to the second inductor.

According to an embodiment, the at least one pattern may include a first pattern and a second pattern respectively corresponding to a first electrode of a first capacitor and a second electrode of a second capacitor in a first conductive layer and a third pattern and a fourth pattern respectively corresponding to a second electrode of a first capacitor and a second electrode of a second capacitor in the second conductive layer.

According to an embodiment, the at least one pattern may include a first pattern and a second pattern respectively corresponding to first and second inductors connected in series in a first conductive layer, and a third pattern and a fourth pattern respectively corresponding to third and fourth inductors connected in series in a second conductive layer and inductively coupled to the first inductor and the second inductor, respectively.

According to an embodiment, a node to which the first inductor and the second inductor are connected may be biased with a first voltage, and a node to which the third inductor and the fourth inductor are connected may be biased with a second voltage.

According to an embodiment, the at least one pattern may further include a fifth pattern and a sixth pattern respectively corresponding to fifth and sixth inductors connected in series in the first conductive layer; and a seventh pattern and an eighth pattern respectively corresponding to a seventh inductor and an eighth inductor connected in series in the second conductive layer and inductively coupled to the fifth inductor and the sixth inductor, respectively, wherein the first to fourth patterns may be included in the first region, the first pattern and the fifth pattern may be electrically connected to each other through a pattern crossing the third region, and the second pattern and the sixth pattern are electrically connected to each other through a pattern crossing the third region.

According to an embodiment, a node to which the first inductor and the second inductor are connected may be biased with a first voltage, and a node to which the fifth inductor and the sixth inductor are connected is biased with a second voltage.

According to an embodiment, the third region may surround the second region on the substrate.

According to an embodiment, the third region may include a first doped region surrounding the second region on the substrate, a second doped region surrounding the first doped region on the substrate, and a third doped region surrounding the second doped region on the substrate, wherein the second doped region and the third doped region are biased to a first potential, and the second doped region is electrically floated.

### BRIEF DESCRIPTION OF THE DRAWINGS

The above and other aspects, features, and advantages of certain embodiments of the disclosure will be more apparent from the following description taken in conjunction with the accompanying drawings, in which:
FIG. 1 is an example of a high-voltage gate driving circuit using a high-voltage metal-oxide-semiconductor field-effect transistor (MOSFET) level shifter according to an embodiment;
FIG. 2 is a block diagram illustrating a device according to an embodiment;
FIG. 3 is a timing diagram illustrating signals of FIG. 2 according to an embodiment;
FIGS. 4A and 4B are circuit diagrams showing examples of galvanic separators according to example embodiments;
FIGS. 5A and 5B are circuit diagrams showing examples of galvanic separators according to example embodiments;
FIG. 6 is a diagram showing a layout of a device according to an embodiment;
FIGS. 7A and 7B are diagrams showing layouts of devices according to example embodiments;
FIGS. 8A and 8B are diagrams showing layouts of devices according to example embodiments;
FIGS. 9A to 9C are circuit diagrams showing examples of galvanic separators according to example embodiments;
FIGS. 10A and 10B are circuit diagrams showing examples of galvanic separators according to example embodiments;
FIG. 11 is a diagram showing a layout of a device according to an embodiment; and
FIG. 12 is a diagram showing a layout of a device according to an embodiment.

### DETAILED DESCRIPTION

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects of the present description. As used herein, the term "and/or" includes any and all combinations of one or more of the associated listed items. Expressions such as "at least one of," when preceding a list of elements, modify the entire list of elements and do not modify the individual elements of the list.

Hereinafter, embodiments of the disclosure will be described in detail with reference to the attached drawings. The embodiments are provided so that this disclosure will be thorough and complete, and will fully convey the scope of the inventive concept to one of ordinary skill in the art. As the disclosure allows for various changes and numerous embodiments, particular embodiments will be illustrated in the drawings and described in detail in the written description. However, this is not intended to limit the disclosure to particular modes of practice, and it is to be appreciated that all changes, equivalents, and substitutes that do not depart from the spirit and technical scope are encompassed in the disclosure. In connection with the description of the drawings, like reference numerals have been used for like elements. In the attached drawings, the dimensions of the structures are enlarged or reduced from the actual size to ensure clarity of the disclosure.

Terms used in various embodiments of the disclosure are only used to describe a specific embodiment and are not intended to limit various embodiments of the disclosure. The singular forms include the plural forms unless the context clearly indicates otherwise. Herein, terms such as "include" or "have" are intended to designate that there are features, numbers, steps, operations, components, parts, or combinations thereof described herein, but it should be understood that it does not preclude the possibility of the presence or addition of one or more other features, numbers, steps, operations, components, parts, or combinations thereof.

Unless defined otherwise, all terms used herein, including technical or scientific terms, have the same meaning as commonly understood by one of ordinary skill in the art to which various embodiments of the present disclosure belong. Terms such as those defined in commonly used dictionaries should be interpreted as having a meaning consistent with the meaning in the context of the related art, and unless explicitly defined in various embodiments of the present disclosure, the terms are not to be construed in an idealized or overly formal sense.

Herein, the X-axis direction and the Y-axis direction may be referred to as a first horizontal direction and a second horizontal direction, respectively, and the Z-axis direction may be referred to as a vertical direction. A plane consisting of the X and Y axes may be referred to as a horizontal plane, a component positioned in a +Z direction relative to other components may be referred to as being on top of another component, and a component positioned in a -Z direction relative to other components may be referred to as being below the other component. Also, an area of a component may refer to a size occupied by the component in a plane parallel to the horizontal plane, and a width of the component may refer to a length in a direction perpendicular to the direction in which the component extends. A surface exposed in the +Z direction may be referred to as a top surface, a surface exposed in the -Z direction may be referred to as a bottom surface, and a surface exposed in the ±X direction or ±Y direction may be referred to as a side surface. For convenience of illustration, only some layers may be shown in the drawings, and a pattern including a conductive material, such as a pattern of a conductive layer such as a wiring layer, may be referred to as a conductive pattern, or may simply be referred to as a pattern.

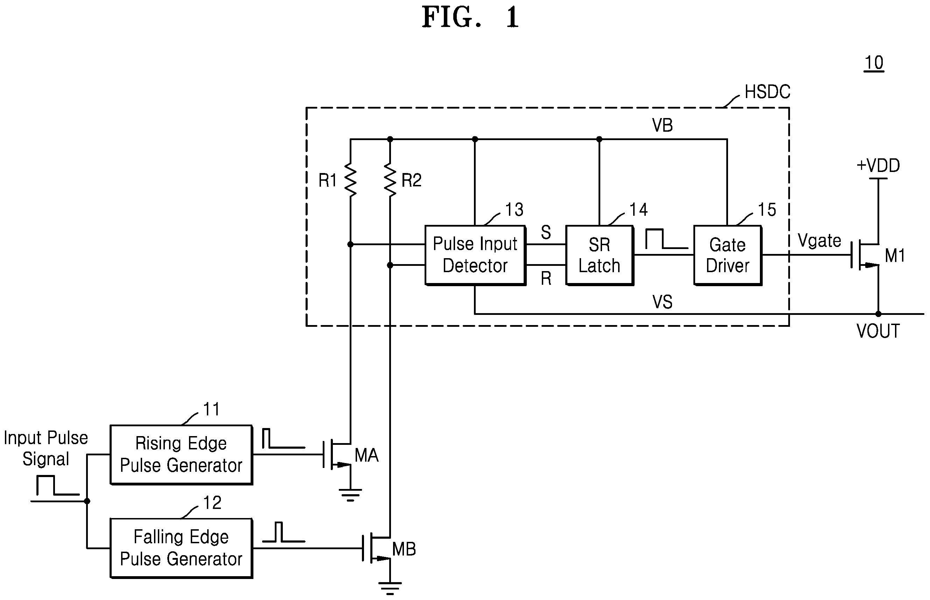

FIG. 1 is a diagram illustrating a high-voltage gate driving circuit 10 that drives a switching element M1 operating at a high potential using an input pulse signal according to an embodiment. A rising edge pulse generator 11 and a falling edge pulse generator 12 may provide rising/falling edge information of an input pulse signal to two high-voltage metal-oxide-semiconductor field-effect transistors (MOSFETs) MA and MB, and the two high-voltage MOSFETs MA and MB may transmit signal information to a high voltage circuit region HSDC. Therefore, the two high-voltage MOSFETs are used as level shifter elements. In the high-voltage circuit region HSDC, a pulse input detector 13 detects a signal by two high-voltage MOSFETs MA and MB respectively connected to two resistors R1 and R2 and a state of a SR latch is determined to be logic level 1 or 0 using a setting signal S or reset signal R based on the detected signal. As a result, the input pulse signal may be reproduced in the high-voltage circuit region HSDC, and the reproduced signal is converted into a signal Vgate appropriate for driving the switching element M1 using a gate driver 15 to drive a switch.

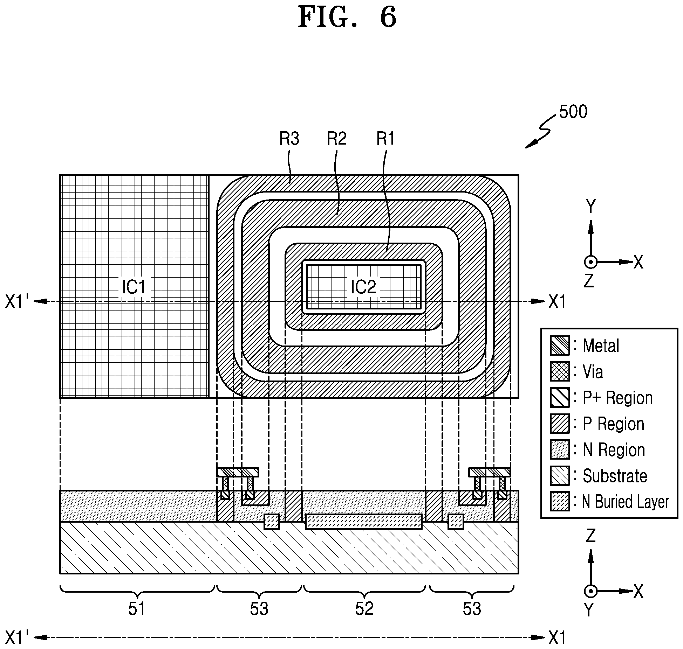

The high-voltage gate driving circuit 10 of FIG. 1, for example, as shown in FIG. 6, may be implemented on a single wafer using semiconductor technology. For example, a low voltage driving circuit may be implemented in a first integrated circuit IC1 of FIG. 6 and a high voltage driving circuit may be implemented in a second integrated circuit IC2 of FIG. 6. A ring structure between the first integrated circuit IC1 and the second integrated circuit IC2 may be a region for maintaining high voltage between the two regions. This method may be referred to as an isolation method using a silicon junction, and, for example, may generate a driving signal in a high voltage direction or a low voltage direction based on the ground of a wafer.

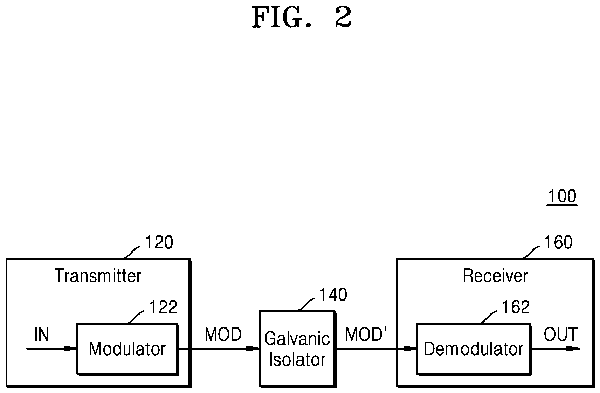

Accordingly, because all circuits may be implemented on one wafer, manufacturing is easy and low costs may be achieved. However, if a very high level of noise is applied to the high voltage circuit region HSDC, the state of the SR latch 14 may be changed by the noise. Because the SR latch 14 is determined by the edge information of the input pulse signal, if a malfunction occurs in the SR latch 14, the error may not be corrected until a new input pulse is applied. However, a gate driving circuit using a galvanic isolator, which will be described later with reference to FIG. 2, does not require a latch circuit, and thus, is relatively free from such malfunctions. Accordingly, the switch element may be driven with high reliability, and a switch voltage may be freely set by insulated driving. However, because the modulator circuit and demodulator circuit are needed to also be insulated each other, they are implemented as separate chips and an assembly process is complicated, which may result in high costs.

The switch voltage may be higher than an input, and only one-way control may be sufficient. Accordingly, it may be advantageous to use junction separation techniques. Accordingly, as described later with reference to drawings, a high-voltage gate driving semiconductor chip that satisfies low cost and high reliability may be possible to implement on a single wafer by using a junction separation technique but using a galvanic insulator as a level shifter.

FIG. 2 is a block diagram illustrating a device 100 according to an embodiment. As shown in FIG. 2, the device 100 may include a transmitter 120, a galvanic isolator 140 and a receiver 160. The transmitter 120 and the receiver 160 may respectively have different reference potentials, and the galvanic isolator 140 may transfer a signal including information between transmitter 120 and receiver 160.

In some embodiments, the device 100 may be an electronic device such as a TV, a personal computer (PC), a vehicle, a transportation means, such as a personal mobility device (PM), or a component included in the above devices. In some embodiments, the device 100 may correspond to a chip (or die) manufactured by a semiconductor process. For example, the transmitter 120, the galvanic isolator 140, and the receiver 160 may be included in one chip manufactured by dicing a wafer, and the chip may be packaged. As described later with reference to drawings, a galvanic isolation may be provided in one chip, and thus galvanic isolation may be easily employed in various applications.

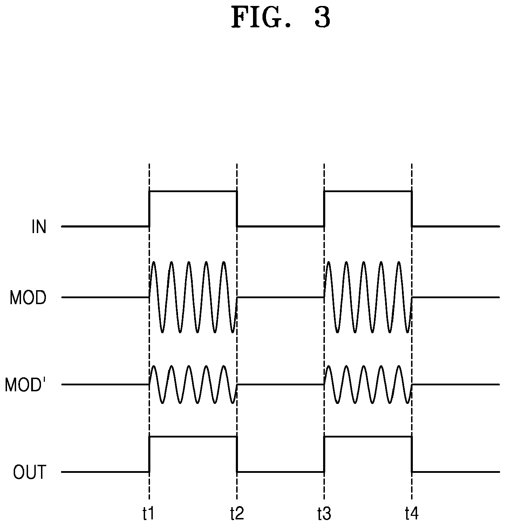

The transmitter 120 may include a modulator 122. The modulator 122 may receive an input signal IN and generate a modulated signal MOD by modulating the input signal IN. In some embodiments, the modulator 122 may generate a modulated signal MOD from the input signal IN based on on/off keying (OOK). The input signal IN may include information to be provided to the receiver 160 and may be generated inside the transmitter 120 or received from outside of the transmitter 120. In some embodiments, the galvanic isolator 140 may include an inductor, and the modulator 122 may generate a modulated signal MOD using a resonant frequency based on the inductor included in the galvanic isolator 140. Examples of the input signal IN and the modulated signal MOD will be described later with reference to FIG. 3.

The galvanic isolator 140 may receive the modulated signal MOD from the transmitter 120 and generate an induced signal MOD' from the modulated signal MOD. In some embodiments, the induced signal MOD' may correspond to an attenuated signal from the modulated signal MOD. As will be described later with reference to drawings, the galvanic isolator 140 may include at least one pattern, and the at least one pattern may form a capacitor and/or an inductor.

The receiver 160 may include a demodulator 162. The demodulator 162 may receive the induced signal MOD' and generate an output signal OUT by demodulating the induced signal MOD'. In some embodiments, the demodulator 162 may generate the output signal OUT from the induced signal MOD' based on OOK. The output signal OUT may include information included in the input signal IN. In some embodiments, a driver that amplifies the output signal OUT may be included in receiver 160 or may be included in the device 100 outside the receiver 160.

The transmitter 120 and the receiver 160 may be included in separate regions of a chip, respectively. For example, the transmitter 120 may be included as an integrated circuit in a first region, the receiver 160 may be included as an integrated circuit in a second region, and the first region and the second region may be spaced apart from each other. In some embodiments, as will be described later with reference to FIG. 6, a third region between the first region and the second region may have a structure that separates a high voltage between the first region and the second region. The galvanic isolator 140 may provide galvanic isolation between the first and second regions spaced apart from each other, and thus the transmitter 120 and the receiver 160 may be implemented on one chip. Herein, it is assumed that the first region includes the transmitter 120 and the second region includes the receiver 160, but it should be noted that the first region may include the receiver 160 and the second region may include the transmitter 120.

FIG. 3 is a timing diagram illustrating the signals of FIG. 2 according to an embodiment. It should be noted that FIG. 3 is merely an example and that the signals in FIG. 2 are not limited to the example in FIG. 3. For illustration convenience, a delay between signals is ignored in FIG. 3. Hereinafter, FIG. 3 will be explained with reference to FIG. 2.

Referring to FIG. 3, the input signal IN may be a pulse signal having an activated state or a deactivated state. For example, as shown in FIG. 3, the input signal IN may be activated at times t1 and t3, while deactivated at times t2 and t4. The modulator 122 may generate the modulated signal MOD that oscillates in response to activation of the input signal IN. For example, as shown in FIG. 3, the modulated signal MOD may oscillate from time t1 to time t2 and may oscillate from time t3 to time t4.

The galvanic isolator 140 may generate the induced signal MOD', which is oscillating, from the modulated signal MOD which is oscillating. For example, as shown in FIG. 3, the induced signal MOD' may oscillate from time t1 to time t2 and may oscillate from time t3 to time t4. As shown in FIG. 3, the magnitude (i.e., amplitude or peak value) of the induced signal MOD' may be less than the modulated signal MOD. The demodulator 162 may generate an activated output signal OUT in response to the induced signal MOD' which is oscillating. For example, as shown in FIG. 3, the output signal OUT may be activated from time t1 to time t2 and may be activated from time t3 to time t4.

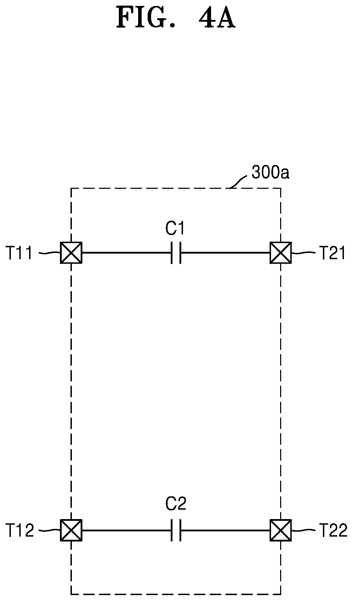

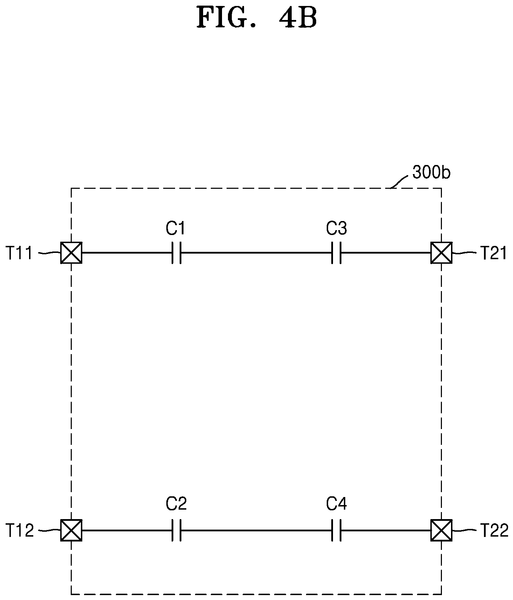

FIGS. 4A and 4B are circuit diagrams showing examples of galvanic isolators according to example embodiments. For example, the circuit diagrams of FIGS. 4A and 4B represent equivalent circuits of galvanic isolator 140 of FIG. 2. As shown in FIGS. 4A and 4B, the galvanic isolator 140 may include a capacitor with a high withstand voltage. Hereinafter, overlapping content in the description of FIGS. 4A and 4B will be omitted.

In some embodiments, the modulated signal MOD and the induced signal MOD' of FIG. 2 may be differential signals, and galvanic isolators 300a and 300b may each include terminals T11 and T12 that receive the modulated signal (MOD) and terminals T21 and T22 through which the induced signal MOD' is output. In some embodiments, the modulated signal MOD may be applied to the terminals T21 and T22, and the induced signal MOD' may be output to the terminals T11 and T12. As shown in FIGS. 4A and 4B, the galvanic isolators 300a and 300b may have a balanced structure for differential signals.

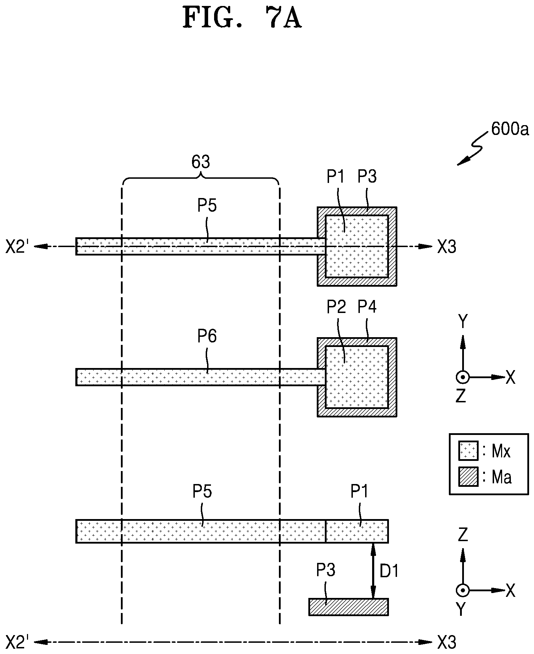

Referring to FIG. 4A, the galvanic isolator 300a may include a first capacitor C1 and a second capacitor C2. The first capacitor C1 may be connected between the terminals T11 and T21, and the second capacitor C2 may be connected between the terminals T12 and T22. A transmitting side and a receiving side may be isolated from each other by the first capacitor C1 and the second capacitor C2, and each of the first capacitor C1 and the second capacitor C2 may have an insulation withstand voltage according to the requirements. In some embodiments, as described later with reference to FIG. 7A, the first capacitor C1 and the second capacitor C2 may be formed by patterns included in one of the first region and the second region.

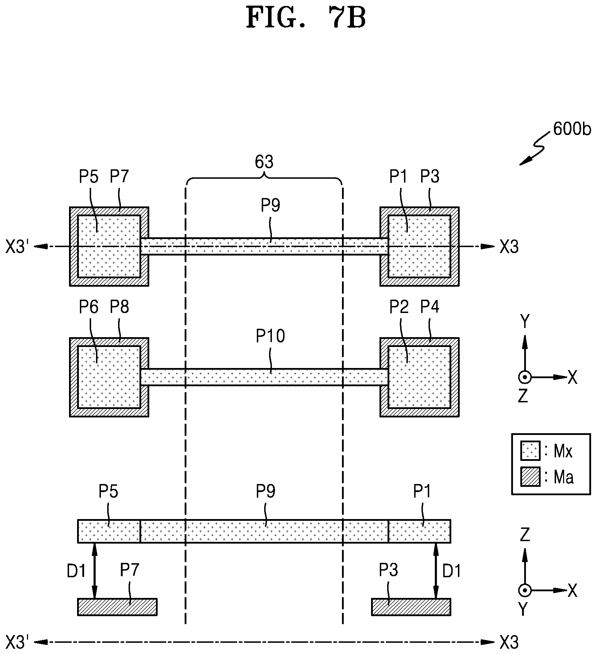

Referring to FIG. 4B, the galvanic isolator 300b may include first to fourth capacitors C1 to C4. The first capacitor C1 and the third capacitor C3 may be connected in series between the terminals T11 and T21, and the second capacitor C2 and the fourth capacitor C4 may be connected in series between the terminals T12 and T22. In some embodiments, as described later with reference to FIG. 7B, the first capacitor C1 and the second capacitor C2 may be formed in one of the first region and the second region, and the third capacitor C3 and the fourth capacitor C4 may be formed in a different region among the first region and the second region. Also, the first capacitor C1 and the third capacitor C3 may be interconnected to each other by a pattern crossing the third region, and the second capacitor C2 and the fourth capacitor C4 may also be interconnected to each other by a pattern crossing the third region. When compared to the galvanic isolator 300a of FIG. 4A, the galvanic isolator 300b of FIG. 4B may provide a higher withstand voltage between the first region and the second region while occupying a larger area.

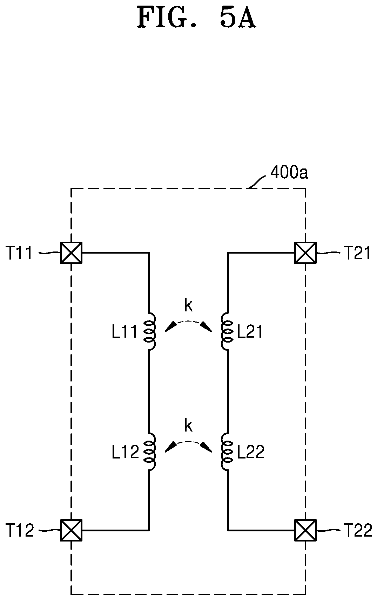

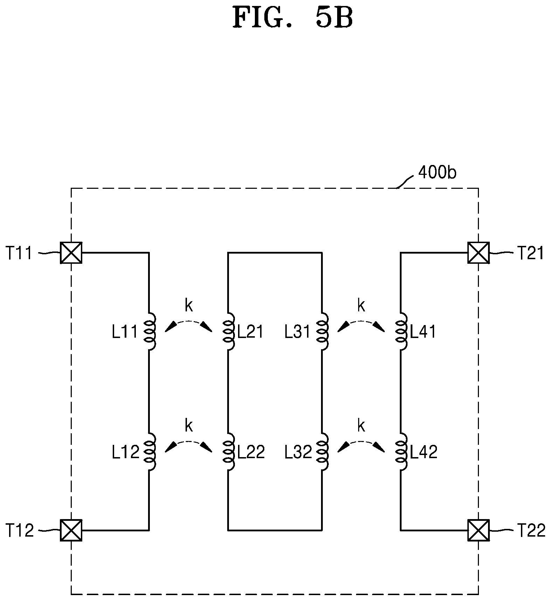

FIGS. 5A and 5B are circuit diagrams showing examples of galvanic isolators according to example embodiments. For example, the circuit diagrams of FIGS. 5A and 5B represent equivalent circuits of galvanic isolator 140 of FIG. 2. As shown in FIGS. 5A and 5B, the galvanic isolator 140 may include a transformer having a high withstand voltage. Hereinafter, overlapping content in the description of FIGS. 5A and 5B will be omitted.

In some embodiments, the modulated signal MOD and the induced signal MOD' of FIG. 2 may be differential signals, and galvanic isolators 400a and 400b each may include terminals T11 and T12 that receives the modulated signal MOD and terminals T21 and T22 through which the induced signal MOD' is output. In some embodiments, the modulated signal MOD may be applied to the terminals T21 and T22, and the induced signal MOD' may be output to the terminals T11 and T12. As shown in FIGS. 5A and 5B, the galvanic isolators 400a and 400b may have a balanced structure for differential signals.

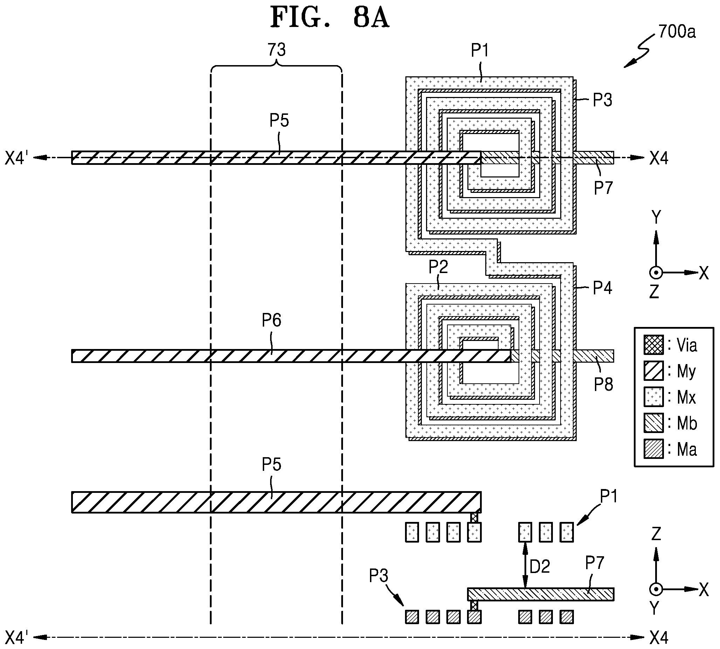

Referring to FIG. 5A, the galvanic isolator 400a includes first inductors L11 and L12 connected in series between the terminals T11 and T12 and second inductors L21 and L22 connected in series between the terminals T21 and T22. The first inductors L11 and L12 may be inductively coupled to the second inductors L21 and L22 with a coupling coefficient k. A transmitting side and a receiving side may be separated from each other by the mutually insulated first inductors L11 and L12 and second inductors L21 and L22, and the first inductors L11 and L12 and second inductors L21 and L22 may have an insulation withstand voltage according to requirements. In some embodiments, as described later with reference to FIG. 8A, the first inductors L11 and L12 and the second inductors L21 and L22 may be formed by patterns included in one of the first region and the second region.

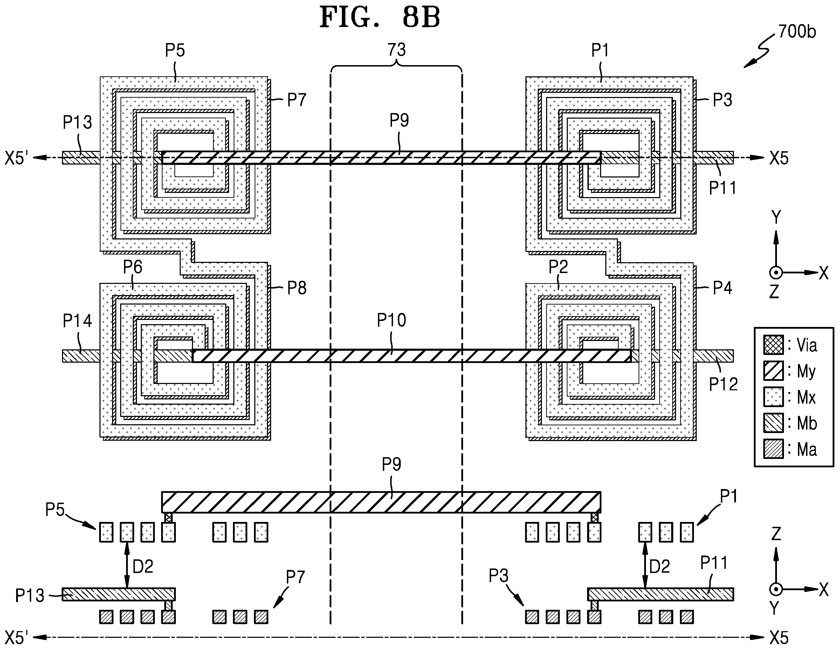

Referring to FIG. 5B, the galvanic isolator 400b may include a plurality of inductors. The first inductors L11 and L12 may be connected in series between the terminals T11 and T12. The second inductors L21 and L22 connected in series and the third inductors L31 and L32 connected in series may be connected in parallel. The fourth inductors L41 and L42 may be connected in series between the terminals T21 and T22. As shown in FIG. 5B, the first inductors L11 and L12 may be inductively coupled to the second inductors L21 and L22 with a coupling coefficient k, and the fourth inductors L41 and L42 may be inductively coupled to the third inductors L31 and L32 with a coupling coefficient k. In some embodiments, as described later with reference to FIG. 8B, the first inductors L11 and L12 and the second inductors L21 and L22 may be formed in one of the first region and the second region, and the third inductors L31 and L32 and the fourth inductors L41 and L42 may be formed in a different region among the first and second regions. Additionally, the second inductors L21 and L22 and the third inductors L31 and L32 may be connected to each other through patterns crossing the third region. When compared to the galvanic isolator 400a of FIG. 5A, the galvanic isolator 400b of FIG. 5B may provide a higher withstand voltage between the first region and the second region while occupying a larger area.

FIG. 6 is a diagram showing a layout 500 of a device according to an embodiment. For example, the upper part of FIG. 6 shows a plan view of the layout 500, and the lower part of FIG. 6 shows a cross-sectional view of the layout 500 taken along line X1'-X1. As described above with reference to the drawings, the layout 500 may be manufactured by a semiconductor process and may be included in one chip (or die). For illustration convenience, only some components are shown in FIG. 6.

Referring to FIG. 6, the layout 500 may include a first region 51, a second region 52, and a third region 53. The first region 51 and the second region 52 may be separated by the third region 53, and the third region 53 may surround the second region 52 on a substrate. The first region 51 may include a first integrated circuit IC1, and the second region 52 may include a second integrated circuit IC2. For example, the first integrated circuit IC1 may include the transmitter 120 of FIG. 2, and the second integrated circuit IC2 may include the receiver 160 of FIG. 2. On the other hand, the first integrated circuit IC1 may include the receiver 160 of FIG. 2, and the second integrated circuit IC2 may include the transmitter 120 of FIG. 2. Hereinafter, it is assumed that the first integrated circuit IC1 includes the transmitter 120 of FIG. 2 and the second integrated circuit IC2 includes the receiver 160 of FIG. 2, but it is noted that the embodiments are not limited thereto.

The third region 53 may have a structure that provides high withstand voltage between the first region 51 and the second region 52. For example, as shown in FIG. 6, the third region 53 may include a first doped region R1 surrounding the second region 52 on the substrate, a second doped region R2 surrounding the first doped region R1 on the substrate, and a third doped region R3 surrounding the second doped region R2 on the substrate. In some embodiments, the first to third doped regions R1 to R3 may have a p-type.

As shown in FIG. 6, the first doped region R1 may isolate n-type regions on the substrate, and the third doped region R3 may also isolate n-type regions on the substrate. The second doped region R2 and the third doped region R3 may be electrically connected by a via and a metal pattern and may be biased to a first potential (e.g., ground potential). The second doped region R2 may have a greater width than the first doped region R1 and the third doped region R3. The first doped region R1 may be electrically floated. It is noted that the third region 53 is not limited to that shown in FIG. 6.

FIGS. 7A and 7B are diagrams showing layouts of devices according to example embodiments. For example, FIG. 7A shows a plan view and a cross-sectional view taken along line X2-X2' of a layout 600a corresponding to the galvanic isolator 300a of FIG. 4A, and FIG. 7B shows a plan view and a cross-sectional view taken along line X3-X3' of a layout 600b corresponding to the galvanic isolator 300b of FIG. 4B. Hereinafter, FIGS. 7A and 7B will be explained with reference to FIGS. 4A, 4B, and 6.

Referring to FIG. 7A, the layout 600a may include patterns forming the galvanic isolator 300a. A first pattern P1 and a second pattern P2 of a conductive layer Mx may correspond to a first electrode of the first capacitor C1 and a first electrode of the second capacitor C2, respectively, and a third pattern P3 and a fourth pattern P4 of a conductive layer Ma may correspond to a second electrode of the first capacitor C1 and a second electrode of the second capacitor C2, respectively. As shown in FIG. 7A, the first pattern P1 and the third pattern P3 may be spaced apart from each other by a first distance D1, and a first capacitor C1 having a withstand voltage depending on the first distance D1 may be formed.

A fifth pattern P5 of the conductive layer Mx may be connected to the first pattern P1 and may extend across a third region 63. Also, a sixth pattern P6 of the conductive layer Mx may be connected to the second pattern P2 and may extend across the third region 63. When the first to fourth patterns P1 to P4 are formed in the first region, the third pattern P3 and the fourth pattern P4 may be electrically connected to a first integrated circuit in the first region, and the fifth pattern P5 and the sixth pattern P6 may be electrically connected to a second integrated circuit in the second region. On the other hand, if the first to fourth patterns P1 to P4 are formed in the second region, the third pattern P3 and the fourth pattern P4 may be electrically connected to the second integrated circuit in the second region, and the fifth pattern P5 and the sixth pattern P6 may be electrically connected to the first integrated circuit in the first region. In some embodiments, the conductive layer Mx may correspond to a top wiring layer.

Referring to FIG. 7B, the layout 600b may include patterns forming the galvanic isolator 300b. The first pattern P1 and the second pattern P2 of the conductive layer Mx may correspond to the first electrode of the first capacitor C1 and the first electrode of the second capacitor C2, respectively, and the third pattern P3 and the fourth pattern P4 of the conductive layer Ma may correspond to the second electrode of the first capacitor C1 and the second electrode of the second capacitor C2, respectively. In addition, the fifth pattern P5 and the sixth pattern P6 of the conductive layer Mx may correspond to the first electrode of the third capacitor C3 and the first electrode of the fourth capacitor C4, respectively, and the seventh pattern P7 and the eighth pattern P8 of the conductive layer Ma may correspond to the second electrode of the third capacitor C3 and the second electrode of the fourth capacitor C4, respectively. As shown in FIG. 7B, the first pattern P1 and the third pattern P3 may be spaced apart from each other by a first distance D1 and may form the first capacitor C1 having a withstand voltage depending on the first distance D1. The fifth pattern P5 and the seventh pattern P7 may be spaced apart from each other by a first distance D1 and may form the third capacitor C3 having a withstand voltage depending on the first distance D1.

The ninth pattern P9 of the conductive layer Mx may be connected to the first pattern P1 and the fifth pattern P5 and may extend across the third region 63. Also, a tenth pattern P10 of the conductive layer Mx may be connected to the second pattern P2 and the sixth pattern P6 and may extend across the third region 63. If the first to fourth patterns P1 to P4 are formed in the first region and the fifth to eighth patterns P5 to P8 are formed in the second region, the third pattern P3 and the fourth pattern P4 may be electrically connected to the first integrated circuit in the first region, and the seventh and eighth patterns P7 and P8 may be electrically connected to the second integrated circuit in the second region. On the other hand, if the first to fourth patterns P1 to P4 are formed in the second region and the fifth to eighth patterns P5 to P8 are formed in the first region, the third pattern P3 and fourth pattern P4 may be electrically connected to the second integrated circuit in the second region, and the seventh pattern P7 and eighth pattern P8 may be electrically connected to the first integrated circuit in the first region. In some embodiments, the conductive layer Mx may correspond to an uppermost wiring layer.

FIGS. 8A and 8B are diagrams showing layouts 700a and 700b of devices according to example embodiments. For example, FIG. 8A shows a top view and a cross-sectional view taken along line X4-X4' of the layout 700a corresponding to the galvanic isolator 400a of FIG. 5A, and FIG. 8B shows a top view and a cross-sectional view taken along line X5-X5' of a layout 700b corresponding to the galvanic separator 400b of FIG. 5B. Hereinafter, FIGS. 8A and 8B will be explained with reference to FIGS. 5A, 5B, and 6.

Referring to FIG. 8A, the layout 700a may include patterns forming the galvanic isolator 400a. A first pattern P1 and a second pattern P2 of the conductive layer Mx may respectively correspond to the first inductors L11 and L12 connected in series, and a third pattern P3 and a fourth pattern P4 of the conductive layer Ma may respectively correspond to the second inductors L21 and L22 connected in series. As shown in FIG. 8A, the first pattern P1 and the third pattern P3 may overlap in a vertical direction, and thus the first inductor L11 and the second inductor L21 may be inductively coupled. The first pattern P1 and the seventh pattern P7 may be spaced apart from each other by a second distance D2, and the first inductor L11 and the second inductor L21 may have a withstand voltage depending on the second distance D2.

A fifth pattern P5 of a conductive layer My may be connected to the first pattern P1 through a via and may extend across a third region 73. The sixth pattern P6 of the conductive layer My may be connected to the second pattern P2 through a via and may extend across the third region 73. The seventh pattern P7 of a conductive layer Mb may be connected to the third pattern P3 through a via, and the eighth pattern P8 of the conductive layer Mb may be connected to the fourth pattern P4 through a via. If the first to fourth patterns P1 to P4 are formed in the first region, the seventh pattern P7 and the eighth pattern P8 may be electrically connected to the first integrated circuit in the first region, the fifth pattern P5 and the sixth pattern P6 may be electrically connected to the second integrated circuit in the second region. On the other hand, if the first to fourth patterns P1 to P4 are formed in the second region, the seventh pattern P7 and the eighth pattern P8 may be electrically connected to the second integrated circuit in the second region, and the fifth pattern P5 and the sixth pattern P6 may be electrically connected to the first integrated circuit in the first region.

Referring to FIG. 8B, the layout 700b may include patterns forming the galvanic isolator 400b. The first pattern P1 and the second pattern P2 of the conductive layer Mx may respectively correspond to the first inductors L11 and L12 connected in series, and the third pattern P3 and the fourth pattern P4 of the conductive layer Ma may respectively correspond to the second inductors L21 and L22 connected in series. In addition, the fifth pattern P5 and the sixth pattern P6 of the conductive layer Mx may respectively correspond to third inductors L31 and L32 connected in series, and the seventh pattern P7 and the eighth pattern P8 of the conductive layer Ma may respectively correspond to the fourth inductors L41 and L42 connected in series. As shown in FIG. 8B, the first pattern P1 and the third pattern P3 may overlap in the vertical direction, and thus the first inductor L11 and the second inductor L21 may be inductively coupled. Also, the fifth pattern P5 and the seventh pattern P7 may overlap in the vertical direction, and thus the third inductor L31 and the fourth inductor L41 may be inductively coupled. The first pattern P1 and an eleventh pattern P11 may be spaced apart from each other by the second distance D2, and the first inductor L11 and the second inductor L12 may have a withstand voltage depending on the second distance D2. Also, the fifth pattern P5 and the seventh pattern P7 may be spaced apart from each other by the second distance D2, and the third inductor L31 and fourth inductor L41 may have a withstand voltage depending on the second distance D2.

The ninth pattern P9 of the conductive layer My may be connected to the first pattern P1 and the fifth pattern P5 through vias and may extend across the third region 73. The tenth pattern P10 of the conductive layer My may be connected to the second pattern P2 and the sixth pattern P6 through vias and may extend across the third region 73. The eleventh pattern P11 of the conductive layer Mb may be connected to the third pattern P3 through a via, and the twelfth pattern P12 of the conductive layer Mb may be connected to the fourth pattern P4 through a via. The thirteenth pattern P13 of the conductive layer Mb may be connected to the seventh pattern P7 through a via, and the fourteenth pattern P14 of the conductive layer Mb may be connected to the 8th pattern P8 through a via. If the first to fourth patterns P1 to P4 are formed in the first region and the fifth to eighth patterns P5 to P8 are formed in the second region, the eleventh pattern P11 and the twelfth pattern P12 may be electrically connected to the first integrated circuit in the first region, and the thirteenth pattern P13 and the fourteenth pattern P14 may be electrically connected to the second integrated circuit in the second region. On the other hand, if the first to fourth patterns P1 to P4 are formed in the second region and the fifth to eighth patterns P5 to P8 are formed in the first region, the eleventh pattern P11 and the twelfth pattern P12 may be electrically connected to the second integrated circuit in the second region, and the thirteenth pattern P13 and the fourteenth pattern P14 may be electrically connected to the first integrated circuit in the first region.

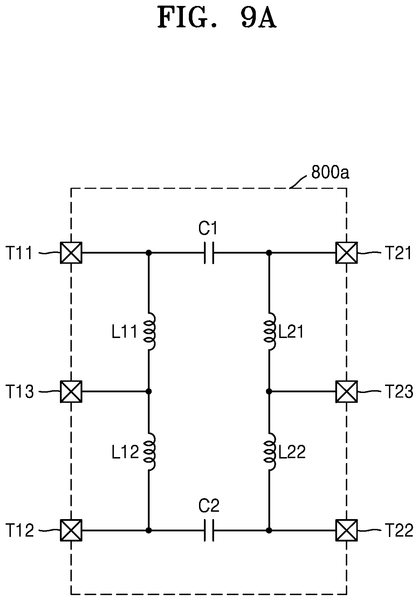

FIGS. 9A to 9C are circuit diagrams showing examples of galvanic isolators 800a, 800b, and 800c according to example embodiments. For example, the circuit diagrams of FIGS. 9A to 9C represent equivalent circuits of the galvanic isolator 140 of FIG. 2. As shown in FIGS. 9A to 9C, each of the galvanic isolators 800a, 800b, and 800c may include a first capacitor C1 and a second capacitor C2 having a high withstand voltage. Hereinafter, overlapping content in the description of FIGS. 9A to 9C will be omitted.

If the first capacitor C1 and the second capacitor C2 have a high capacitance to improve signal transmission characteristics, malfunction may occur by the first capacitor C1 and the second capacitor C2. For example, if a large voltage change (i.e., high dv/dt) occurs in the receiver 160 of FIG. 2 and a driver operating based on an output of the receiver 160, a large current may be transmitted to the transmitter 120 of FIG. 2 through the first capacitor C1 and/or the second capacitor C2, which may cause a malfunction or even damage to a circuit included in the transmitter 120.

Referring to FIG. 9A, the galvanic isolator 800a may include first inductors L11 and L12 connected in series between the terminals T11 and T12 and second inductors L21 and L22 connected in series between the terminals T21 and T22. Also, a node to which the first inductors L11 and L12 are connected may be connected to the terminal T13, and a node to which the second inductors L21 and L22 are connected may be connected to a terminal T23. The terminals T13 and T23 may be referred to as center tap terminals. The terminal T13 and the terminal T23 may be connected to low impedance nodes, respectively. For example, the terminal T13 may be biased with a first voltage and the terminal T23 may be biased with a second voltage. Accordingly, due to a large change in the second voltage, a current flowing in through the terminal T23 may be output through the terminal T13, and an excessive current may be prevented from flowing into the transmitter 120.

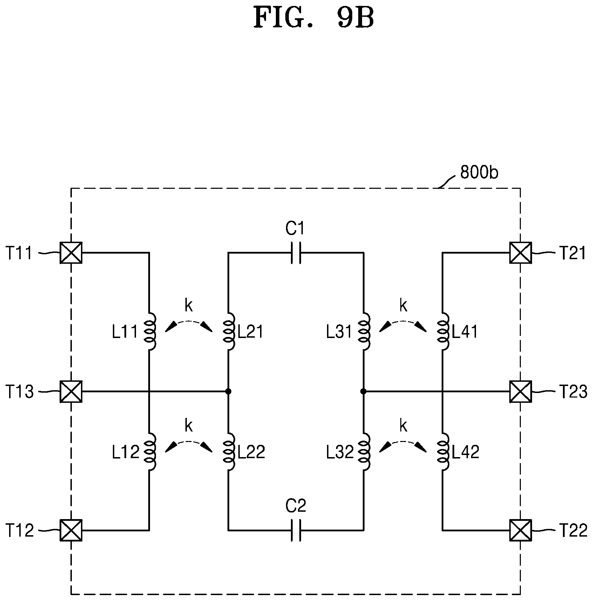

Referring to FIG. 9b, the galvanic isolator 800b may include a first capacitor C1, a second capacitor C2, first inductors L11 and L12, second inductors L21 and L22, third inductors L31 and L32, and fourth inductors L41 and L42. The first inductors L11 and L12 may be connected in series between the terminals T11 and T12, and may be inductively coupled to the second inductors L21 and L22 with a coupling coefficient k. The second inductors L21 and L22 may be connected in series between the first capacitor C1 and the second capacitor C2, and a node to which the second inductors L21 and L22 are connected may be connected to the terminal T13. The third inductors L31 and L32 may be connected in series between the first capacitor C1 and the second capacitor C2, and a node to which the second inductors L31 and L32 are connected may be connected to the terminal T23. The fourth inductors L41 and L42 may be connected in series between the terminals T21 and T22 and may be inductively coupled to the third inductors L31 and L32 with a coupling coefficient k. The terminal T13 and the terminal T23 may be connected to low impedance nodes, respectively. For example, the terminal T13 may be biased with a first voltage and the terminal T23 may be biased with a second voltage. Accordingly, due to a large change in the second voltage, a current flowing in through the terminal T23 may be output through the terminal T13, and excessive current may be prevented from flowing into the transmitter 120.

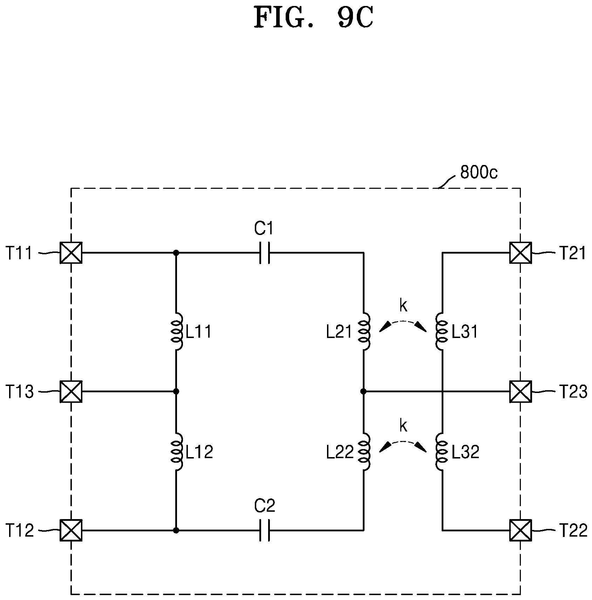

Referring to FIG. 9C, the galvanic isolator 800c may include a first capacitor C1, a second capacitor C2, first inductors L11 and L12, second inductors L21 and L22, and third inductors L31 and L32. The first inductors L11 and L12 may be connected in series between the terminals T11 and T12, and a node to which the first inductors L11 and L12 are connected may be connected to the terminal T13. The second inductors L21 and L22 may be inductively coupled to the third inductors L31 and L32 with a coupling coefficient k, and a node to which the second inductors L21 and L22 are connected is connected to the terminal T23. The third inductors L31 and L32 may be connected in series between the terminals T21 and T22. The terminal T13 and the terminal T23 may be connected to low impedance nodes, respectively. For example, the terminal T13 may be biased with a first voltage and the terminal T23 may be biased with a second voltage. Accordingly, due to a large change in the second voltage, a current flowing in through the terminal T23 may be output through the terminal T13, and an excessive current may be prevented from flowing into the transmitter 120. In some embodiments, the transmitter 120 may be connected to terminals T21 and T22, and the receiver 160 may be connected to terminals T11 and T12.

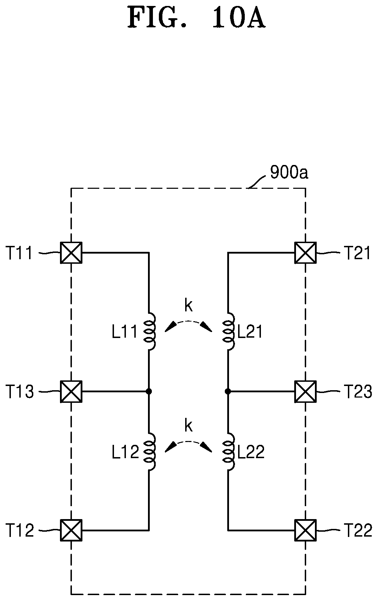

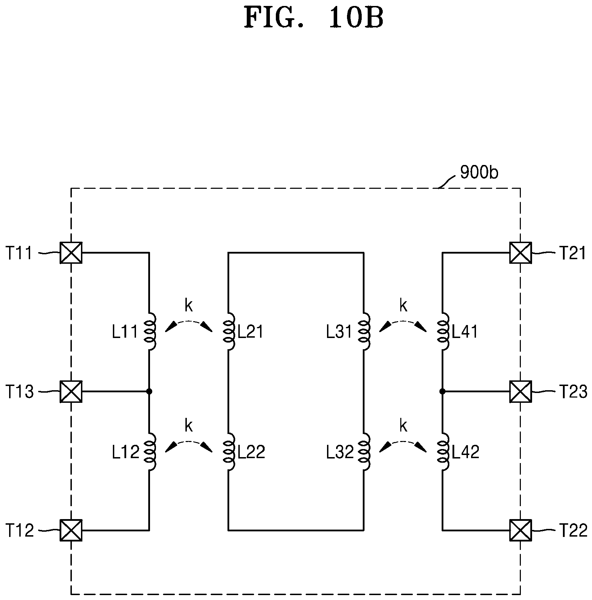

FIGS. 10A and 10B are circuit diagrams showing examples of galvanic isolators 900a and 900b according to example embodiments. For example, the circuit diagrams of FIGS. 10A and 10B represent equivalent circuits of the galvanic isolator 140 of FIG. 2. As shown in FIGS. 10A and 10B, each of the galvanic isolators 900a and 900b may include inductors that are inductively coupled to each other. Hereinafter, overlapping content in the description of FIGS. 10A and 10B will be omitted.

Referring to FIG. 10A, the galvanic isolator 900a may include first inductors L11 and L12 connected in series between the terminals T11 and T12 and second inductors L21 and L22 connected in series between the terminals T21 and T22. The first inductors L11 and L12 may be inductively coupled to the second inductors L21 and L22 with a coupling coefficient k. As shown in FIG. 10A, a node to which the first inductors L11 and L12 are connected may be connected to the terminal T13, and a node to which the second inductors L21 and L22 are connected may be connected to the terminal T23. The terminal T13 and the terminal T23 may be connected to low impedance nodes, respectively. For example, the terminal T13 may be biased with a first voltage and the terminal T23 may be biased with a second voltage. Accordingly, due to a large change in the second voltage, a current flowing in through the terminal T23 may be output through the terminal T13, and an excessive current may be prevented from flowing into the transmitter 120.

Referring to FIG. 10B, the galvanic isolator 900b may include first inductors L11 and L12, second inductors L21 and L22, third inductors L31 and L32, and fourth inductors L41 and L42. The first inductors L11 and L12 may be connected in series between the terminals T11 and T12, and may be inductively coupled to the second inductors L21 and L22 with a coupling coefficient k. The second inductors L21 and L22 may be connected in parallel with the third inductors L31 and L32, and the third inductors L31 and L32 may be inductively coupled to the fourth inductors L41 and L42 with a coupling coefficient k. The fourth inductors L41 and L42 may be connected in series between the terminals T21 and T22. As shown in FIG. 10B, a node to which the first inductors L11 and L12 are connected may be connected to the terminal T13, and a node to which the fourth inductors L41 and L42 are connected may be connected to the terminal T23. The terminal T13 and the terminal T23 may be connected to low impedance nodes, respectively. For example, the terminal T13 may be biased with a first voltage and the terminal T23 may be biased with a second voltage. Accordingly, due to a large change in the second voltage, a current flowing in through the terminal T23 may be output through the terminal T13, and an excessive current may be prevented from flowing into the transmitter 120.

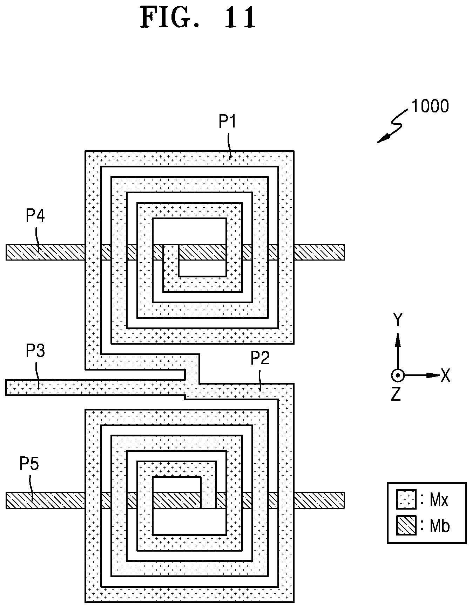

FIG. 11 is a diagram showing a layout 1000 of a device according to an embodiment. For example, FIG. 11 is a top view of the layout 1000 corresponding to the first inductors L11 and L12 of FIGS. 9A and 9C or the second inductors L21 and L22 of FIG. 9A. Hereinafter, FIG. 11 will be described with reference to FIG. 9A.

Referring to FIG. 11, the layout 1000 may include patterns forming the first inductors L11 and L12 or the second inductors L21 and L22 of the galvanic isolator 800a. The first pattern P1 and the second pattern P2 of the conductive layer Mx may correspond to the first inductors L11 and L12 connected in series or the second inductors L21 and L22 connected in series. The third pattern P3 of the conductive layer Mx may be connected to the first pattern P1 and the second pattern P2 and may correspond to the terminal T13 or the terminal T23. The fourth pattern P4 of the conductive layer Mb may be connected to the first pattern P1 of the conductive layer Mx and may be connected to the first capacitor C1 and the terminal T11. The fifth pattern P5 of the conductive layer Mb may be connected to the second pattern P2 of the conductive layer Mx and may be connected to the second capacitor C2 and the terminal T12.

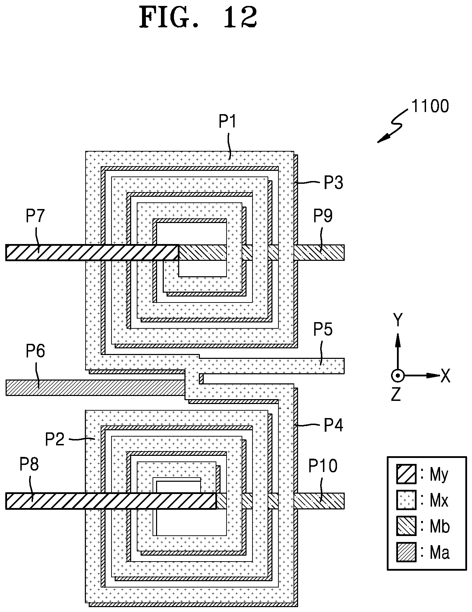

FIG. 12 is a diagram illustrating a layout 1100 of a device according to an embodiment. For example, FIG. 12 shows a plan view of the layout 1100 corresponding to the first inductors L11 and L12 and the second inductors L21 and L22 of FIGS. 9B, 10A, and 10B, the third inductors L31 and L32 and the fourth inductors L41 and L42 of FIGS. 9B and 10B, or the second inductors L21 and L22 and the third inductors L31 and L32 of FIG. 9C. Hereinafter, FIG. 12 will be described with reference to FIG. 10A.

Referring to FIG. 12, the layout 1100 may include patterns forming the first inductors L11 and L12 and the second inductors L21 and L22 of the galvanic isolator 900a. The first pattern P1 and the second pattern P2 of the conductive layer Mx may respectively correspond to the first inductors L11 and L12 connected in series. The third pattern P3 and the fourth pattern P4 of the conductive layer Ma may respectively correspond to the second inductors L21 and L22 connected in series. The fifth pattern P5 of the conductive layer Mx may be connected to the first pattern P1 and the second pattern P2 and may correspond to the terminal T13. The sixth pattern P6 of the conductive layer Ma may be connected to the third pattern P3 and the fourth pattern P4 and may correspond to the terminal T23. The seventh pattern P7 of the conductive layer My may be connected to the first pattern P1 and may correspond to the terminal T11. The eighth pattern P8 of the conductive layer My may be connected to the second pattern P2 and may correspond to the terminal T12. The ninth pattern P9 of the conductive layer Mb may be connected to the third pattern P3 and may correspond to the terminal T21. The tenth pattern P10 of the conductive layer Mb may be connected to the fourth pattern P4 and may correspond to the terminal T22.

According to the device according to an embodiment of the present disclosure, when implementing a high-voltage gate driving circuit with one chip, signal transmission is possible using a galvanic isolator as a level shifter, and malfunction problems may be suppressed compared to a level shifter circuit using a high-voltage MOSFET, and accordingly, it may be easily adopted in various high-power applications that require high reliability.

Also, according to the device according to an embodiment of the present disclosure, malfunctions due to sudden changes in signals may be prevented, and thus galvanic isolation with high reliability may be provided.

The effects that may be obtained from the embodiments of the present disclosure are not limited to the effects mentioned above, and other effects that are not mentioned may be clearly derived and understood by those skilled in the art from the following description to which the embodiments of the present disclosure belong. That is, unintended effects resulting from implementing the embodiments of the present disclosure may also be derived by those skilled in the art from the example embodiments of the present disclosure.

As described above, example embodiments of the disclosure have been described in the drawings and specification. Herein, the example embodiments are described by using some specific terms, but the terms used are for the purpose of describing the technical scope of the disclosure only and are not intended to be limiting of meanings or the technical scope described in the claims. Therefore, it will be understood by those skilled in the art that various changes in form and details may be made therein without departing from the spirit and scope of the inventive concept as defined by the appended claims. Accordingly, the scope of the disclosure is defined not by the detailed description of the invention but by the appended claims.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the spirit and scope of the disclosure as defined by the following claims.

## Claims

1. A device comprising:
a first region including a first integrated circuit on a substrate;
a second region including a second integrated circuit on the substrate; and
a third region between the first region and the second region on the substrate,
wherein at least one of the first region and the second region includes at least one pattern that provides galvanic isolation between the first integrated circuit and the second integrated circuit on the substrate.

2. The device of claim 1, wherein
the at least one pattern includes:
a first pattern and a second pattern respectively corresponding to a first electrode of a first capacitor and a first electrode of a second capacitor in a first conductive layer; and
a third pattern and a fourth pattern respectively corresponding to a second electrode of the first capacitor and a second electrode of the second capacitor in a second conductive layer.

3. The device of claim 2, wherein
the at least one pattern further includes:
a fifth pattern and a sixth pattern respectively corresponding to a first electrode of a third capacitor and a first electrode of a fourth capacitor in the first conductive layer; and
a seventh pattern and an eighth pattern respectively corresponding to a second electrode of the third capacitor and a second electrode of the fourth capacitor in the second conductive layer,
wherein the first to fourth patterns are included in the first region, and
the fifth to eighth patterns are included in the second region,
wherein the first pattern and the fifth pattern are electrically connected to each other through a pattern crossing the third region, and
the second pattern and the sixth pattern are electrically connected to each other through a pattern crossing the third region.

4. The device of claim 2, further comprising:
a first inductor and a second inductor connected in series between the first electrode of the first capacitor and the first electrode of the second capacitor,
wherein a node to which the first inductor and the second inductor are connected is biased with a first voltage.

5. The device of claim 4, further comprising
a third inductor inductively coupled to the first inductor; and
a fourth inductor inductively coupled to the second inductor.

6. The device of claim 1, wherein
the at least one pattern includes:
a first pattern and a second pattern respectively corresponding to a first electrode of a first capacitor and a second electrode of a second capacitor in a first conductive layer; and
a third pattern and a fourth pattern respectively corresponding to a second electrode of the first capacitor and a second electrode of a second capacitor in a second conductive layer.

7. The device of claim 1, wherein
the at least one pattern includes:
a first pattern and a second pattern respectively corresponding to first and second inductors connected in series in a first conductive layer; and
a third pattern and a fourth pattern respectively corresponding to third and fourth inductors connected in series in a second conductive layer and inductively coupled to the first inductor and the second inductor, respectively.

8. The device of claim 7, wherein
a node to which the first inductor and the second inductor are connected is biased with a first voltage, and
a node to which the third inductor and the fourth inductor are connected is biased with a second voltage.

9. The device of claim 7, wherein
the at least one pattern further includes:
a fifth pattern and a sixth pattern respectively corresponding to fifth and sixth inductors connected in series in the first conductive layer; and
a seventh pattern and an eighth pattern respectively corresponding to a seventh inductor and an eighth inductor connected in series in the second conductive layer and inductively coupled to the fifth inductor and the sixth inductor, respectively,
wherein the first to fourth patterns are included in the first region,
the fifth to eighth patterns are included in the second region,
the first pattern and the fifth pattern are electrically connected to each other through a pattern crossing the third region, and
the second pattern and the sixth pattern are electrically connected to each other through a pattern crossing the third region.

10. The device of claim 9, wherein
a node to which the first inductor and the second inductor are connected is biased with a first voltage, and
a node to which the fifth inductor and the sixth inductor are connected is biased with a second voltage.

11. The device of claim 1, wherein the third region surrounds the second region on the substrate.

12. The device of claim 11, wherein
the third region includes:
a first doped region surrounding the second region on the substrate;
a second doped region surrounding the first doped region on the substrate; and
a third doped region surrounding the second doped region on the substrate,
wherein the second doped region and the third doped region are biased to a first potential, and
the second doped region is electrically floated.
